# EUROPEAN PATENT APPLICATION

(11) **EP 4 386 865 A1**
(43) Date of publication of application: **19.06.2024**
(21) Application number: 22857781.3
(22) Date of filing: 16.08.2022
(51) Int. Cl.: H01L 31/0224, H01L 31/04

(54) **GATE LINE STRUCTURE OF SOLAR CELL AND SOLAR CELL APPLYING SAME**

(30) Priority: 17.08.2021 CN 202110944458
(71) Applicant: Trina Solar Co., Ltd, Changzhou, Jiangsu 213031 (CN)
(72) Inventor: HU, Yunyun, HANGZHOU, Jiangsu 213031 (CN); LIU, Zongtao, HANGZHOU, Jiangsu 213031 (CN); LIU, Zhiyuan, HANGZHOU, Jiangsu 213031 (CN); XU, Guanchao, HANGZHOU, Jiangsu 213031 (CN); CHEN, Daming, HANGZHOU, Jiangsu 213031 (CN); ZOU, Yang, HANGZHOU, Jiangsu 213031 (CN); ZHANG, Xueling, HANGZHOU, Jiangsu 213031 (CN); CHEN, Yifeng, HANGZHOU, Jiangsu 213031 (CN)
(74) Representative: Nederlandsch Octrooibureau
(86) International application number: PCT/CN2022/112716
(87) International publication number: WO 2023/020469

(57) **Abstract**

The present invention provides a gate line structure of a solar cell and a solar cell applying same. The structure comprises a plurality of main gate lines extending along a first direction and arranged at intervals along a second direction, and a plurality of thin gate lines extending along the second direction and arranged at intervals along the first direction, wherein the first direction and the second direction are not parallel, the plurality of main gate lines are electrically connected to the plurality of thin gate lines respectively, and between any two adjacent main gate lines, each thin gate line has a disconnected section. According to the gate line structure of a solar cell and a solar cell applying same of the present invention, silver paste consumption can be effectively reduced while ensuring cell efficiency, reducing the preparation costs of a solar cell.

## Description

### Technical Field

The present application mainly relates to the technical fields of solar cell, and in particular to a gate line structure of solar cell and solar cell applying same.

### Background

Silver (Ag) has low resistivity, can effectively transport carriers, and has low resistance loss, which is widely used in the technical fields of solar cell and electronics industries. However, as a precious metal, Ag has limited reserves and high cost, and in existing solar cells, the cost of Ag is about 70% of the cost of non-silicon material. Therefore, whether silver consumption can be reduced while ensuring battery performance is one of the main factors affecting the cost of photovoltaic power generation.

Specifically, Ag is used as a metallized electrode in solar cells to derive carriers and transfer carriers to external circuits, and the specific process is to first grind the silver into micro-nano particles and then mix it into a viscous mixture with adhesives, solvents, additives, etc. These mixtures are printed on the battery through screen printing, while the pattern of the screen determines the pattern printed on the battery, and the paste printed on the battery is dried and sintered to form a silver electrode with better conductivity.

Screen-printed silver cells have always been a commonly used technology in the solar cell industry, the technology is mature and the performance is stable, and it is difficult to be replaced in the foreseeable time and is in an absolutely dominant position, but the price of silver paste is also increasing year by year. Other methods for preparing electrodes include electroplating and silver-coated copper particles, however, electrodes prepared by electroplating are generally composed of Ni/Cu/Ag, which can reduce silver consumption but will produce a large amount of waste liquid, and it contains various cations and toxic organic substances which cannot be discharged directly, and the treatment cost is also high. On this basis, the technology of silver-coated copper is not yet mature and has not yet been applied industrially. Therefore, screen printing technology still and will continue to dominate the preparation of photovoltaic electrodes, and optimizing screen printing technology to reduce silver consumption has naturally become a top priority in the field.

### Summary

The technical problem to be solved by the present invention is to provide a gate line structure of solar cell and solar cell applying same, which can effectively reduce the consumption of silver paste on the basis of ensuring the cell efficiency, and reduce the preparation cost of solar cells.

In order to solve the above technical problems, the present application provides a gate line structure of a solar cell, including a plurality of main gate lines extending along a first direction and arranged at intervals along a second direction, and a plurality of thin gate lines extending along the second direction and arranged at intervals along the first direction, the first direction and the second direction are not parallel, and the plurality of main gate lines are electrically connected to the plurality of thin gate lines respectively, between any two adjacent main gate lines, each thin gate line has a disconnected section.

In one embodiment of the present invention, a length of the disconnected section of each thin gate line in the second direction is disconnection distance, and the disconnection distance is less than or equal to twice a spacing between two adjacent thin gate lines.

In one embodiment of the present invention, the disconnection distance of the disconnection section of each thin gate line is all equal.

In one embodiment of the present invention, between any two adjacent main gate lines, the disconnected section of an odd-numbered thin gate line and the disconnected section of an even-numbered thin gate line do not overlap or do not completely overlap in the first direction.

In one embodiment of the present invention, between any two adjacent main gate lines, the disconnected sections of any two odd-numbered thin gate lines overlap in the first direction, and the disconnected sections of any two even-numbered thin gate lines also overlap in the first direction.

In one embodiment of the present invention, any two adjacent main gate lines are first main gate line and second main gate line, and between the first main gate line and the second main gate line, an end of the disconnected section of any thin gate line close to the first main gate line is first end, wherein, a difference between a distance between the first end of any odd-numbered thin gate line's disconnected section and the first main gate line and a distance between the first end of the even-numbered thin gate line's disconnected section or another odd-numbered thin gate line's disconnected section and the first main gate line is stagger distance, and when the disconnection distance of each thin gate line is equal, the stagger distance is equal to the disconnection distance.

To solve the technical problems as stated above, another aspect of the present invention also provides a solar cell, which includes a basic gate line structure, and the basic gate line structure is the above-mentioned gate line structure.

In one embodiment of the present invention, the solar cell also includes a supplementary gate line structure, and the supplementary gate line structure includes a plurality of main gate lines extending along a first direction and arranged at intervals along a second direction, and a plurality of thin gate lines extending along the second direction and arranged at intervals along the first direction, the first direction and the second direction are not parallel, and the plurality of main gate lines are electrically connected to the plurality of thin gate lines respectively, and between any two adjacent main gate lines, only odd-numbered thin gate lines or only even-numbered thin gate lines have disconnected sections.

In one embodiment of the present invention, any three main gate lines arranged in sequence are a first main gate line, a second main gate line and a third main gate line, a first region is formed between the first main gate line and the second main gate line, a second region is formed between the second main gate line and the third main gate line, parts of the first main gate line, the second main gate line and the plurality of thin gate lines in the first region have the basic gate line structure, and parts of the second main gate line, the third main gate line and the plurality of thin gate lines in the second region have the supplementary gate line structure.

In one embodiment of the present invention, any four main gate lines arranged in sequence are a first main gate line, a second main gate line, a third main gate line and a fourth main gate line, a first region is formed between the first main gate line and the second main gate line, a second region is formed between the second main gate line and the third main gate line, a third region is formed between the third main gate line and the fourth main gate line, parts of the first main gate line, the second main gate line, the third main gate line and the plurality of thin gate lines in the first region and the second region are the basic gate line structure, parts of the third main gate line, the fourth main gate line and the plurality of thin gate lines in the third region are the supplementary gate line structure.

Compared with the prior art, the present invention has the following advantages: The gate line structure of the solar cell of the present invention and the solar cell applying same are provided with disconnected sections on each thin gate line between adjacent main gate lines, which effectively reduces the consumption of silver paste; On this basis, arranging the disconnected sections of each gate line at a specific position not only reduces the consumption of silver paste, but also effectively ensures the efficiency of the solar cell and reduces the overall production cost of the solar cell.

### Brief Description of the Drawings

The features and performance of the present invention are further described in the following examples and accompanying drawings. The drawings are included to provide a further understanding of the present application, and they are included and constitute a part of the present application, the drawings show the embodiments of the present application, and serving to explain the principles of the present application together with the description. In the drawings:
FIG. 1 is a schematic diagram of a solar cell gate line structure in the prior art;
FIG. 2 is a schematic diagram of a solar cell gate line structure according to an embodiment of the present invention;
FIG. 3a-5 are respectively schematic diagrams of a solar cell gate line structure according to another embodiment of the present invention;
FIG. 6 is a schematic structural diagram of a solar cell according to an embodiment of the present invention; and
FIG. 7 is a schematic structural diagram of a solar cell according to another embodiment of the present invention.

### Preferred Embodiment of the Present Invention

In order to illustrate the technical solutions in the embodiments of the present application more clearly, the drawings that need to be used in the description of the embodiments will be briefly introduced below. Obviously, the drawings in the following description are only some embodiments of the present application, and for those skilled in the art, other drawings can also be obtained based on these drawings without creative effort.

As indicated in this application and claims, the terms "a", "an", "a kind of" and/or "the" do not specifically refer to the singular and may include the plural unless the context clearly indicates an exception. Generally speaking, the terms "comprising" and "including" only suggest the inclusion of clearly identified steps and elements, and these steps and elements do not constitute an exclusive list, and the method or device may also contain other steps or elements.

The relative arrangements of components and steps, numerical expressions and numerical values set forth in these embodiments do not limit the scope of the present application unless specifically stated otherwise. At the same time, it should be understood that, for the convenience of description, the sizes of the various parts shown in the drawings are not drawn according to the actual proportional relationship. Techniques, methods and devices known to those of ordinary skill in the relevant art may not be discussed in detail, but where appropriate, such techniques, methods and devices should be considered part of the authorized specification. In all embodiments shown and discussed herein, any specific values should be construed as illustrative only, and not as limiting. Therefore, other examples of the exemplary embodiment may have different values. It should be noted that like numerals and letters denote like items in the following figures, therefore, once an item is defined in one figure, it does not require further discussion in subsequent drawings.

In the description of the present application, it should be understood that orientation words such as "front, back, up, down, left, right", " landscape, portrait, vertical, horizontal" and "top, bottom" etc. indicating the orientation or positional relationship is generally based on the orientation or positional relationship shown in the drawings, only for the convenience of describing the application and simplifying the description, in the absence of a contrary statement, these orientation words do not indicate or imply that the device or element referred to must have a specific orientation or be constructed and operated in a specific orientation, and therefore cannot be construed as limiting the scope of protection of this application; the orientation words "inside and outside" refer to inside and outside relative to the outline of each part itself.

For the convenience of description, spatially relative terms may be used here, such as "on ...", "over ...", "on the upper surface of ...", "above", etc., to describe the spatial positional relationship between one device or feature and other devices or features. It will be understood that, in addition to the orientation depicted in the drawings, the spatially relative terms are intended to encompass different orientations of the device in use or operation. For example, if the device in the drawings is turned over, devices described as "on other devices or configurations " or "above other devices or configurations " would then be oriented "beneath other devices or configurations " or "under other devices or configurations ". Thus, the exemplary term "above" can encompass both an orientation of "above" and "beneath". The device may be otherwise oriented (rotated 90 degrees or at other orientations), and making a corresponding explanation for the space relative description used here.

In addition, it should be noted that the use of words such as "first" and "second" to define components is only for the convenience of distinguishing corresponding components, unless otherwise stated, the above words have no special meanings, and therefore cannot be construed as limiting the protection scope of the present application. In addition, although the terms used in this application are selected from well-known and commonly used terms, some terms mentioned in the specification of this application may be selected by the applicant according to his or her judgment, and their detailed meanings are listed in this article described in the relevant section of the description. Furthermore, it is required that this application be understood not only by the actual terms used, but also by the meaning implied by each term.

It will be understood that when an element is referred to as being "on," "connected to," "coupled to" or "in contacting with" another element, it can be directly on, connected to, coupled to, or in contact with the other element, or there may be an intervening component. In contrast, when an element is referred to as being "directly on," "directly connected to," "directly coupled to" or "directly in contacting with" another element, there are no intervening elements present. Likewise, when a first component is referred to as being "electrically contacting" or "electrically coupled to" a second component, there exists an electrical path between the first component and the second component that allows electrical current to flow. This electrical path may include capacitors, coupled inductors, and/or other components that allow current to flow, even without direct contact between conductive components.

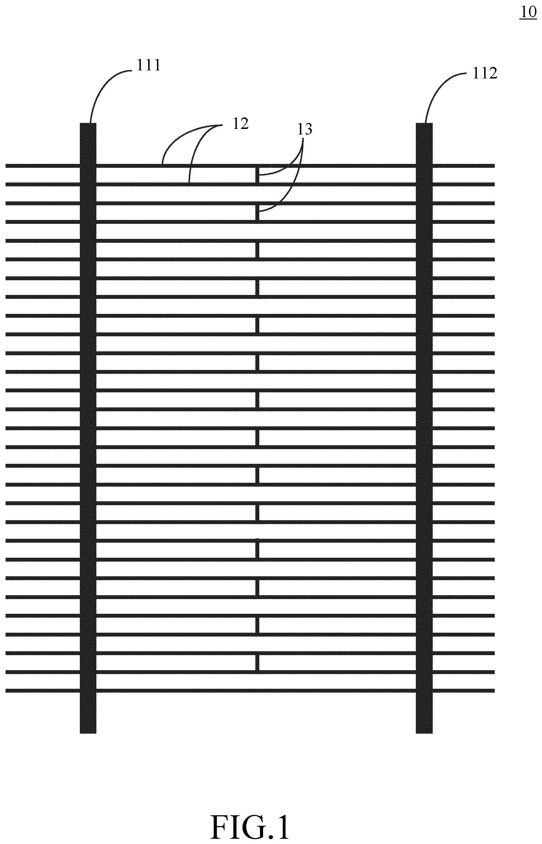

FIG. 1 is a schematic diagram of a solar cell gate line structure in the prior art. Referring to FIG. 1, gate line structure 10 has two adjacent main gate lines 111 and 112, and between the two main gate lines 111 and 112, there are a plurality of thin gate lines 12; all of the above main gate lines and thin gate lines are arranged on a silicon wafer (the silicon wafer is not shown in FIG. 1 to keep the drawing simple). On this basis, there is also an "H" shaped line 13 between each two thin gate lines 12 to connect the two adjacent thin gate lines 12. As mentioned above, although the photoelectric conversion efficiency of the solar cell can be ensured by using the gate line structure 10 as shown in FIG. 1, a large amount of silver is required to prepare multiple gate lines, especially the plurality of thin gate lines 12, and this increases the preparation cost of solar cells, which is exactly the problem to be solved by the present invention.

One embodiment of the present invention proposes a gate line structure for solar cells, which can effectively reduce silver paste consumption and reduce the production cost of solar cells while ensuring cell efficiency.

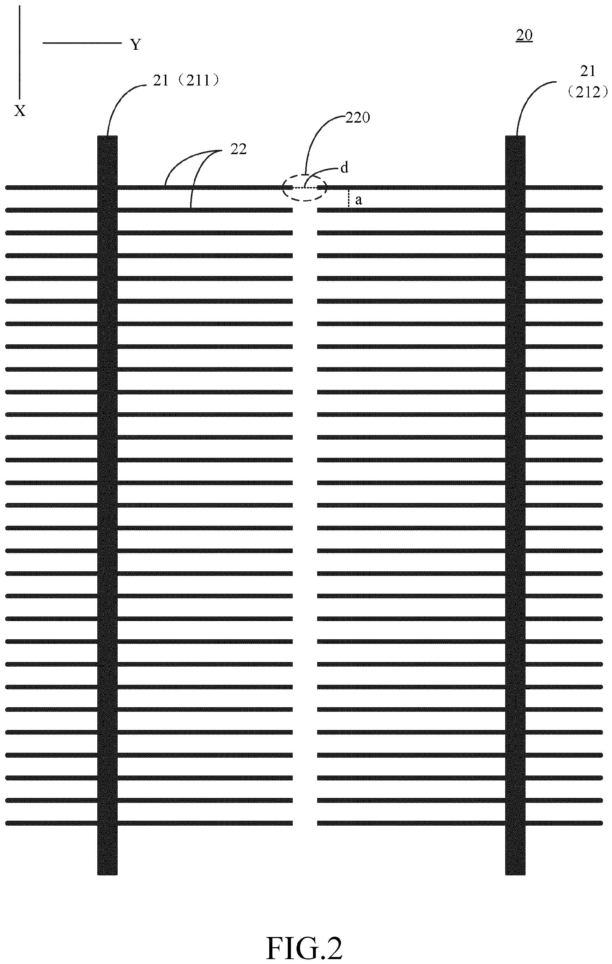

As shown in FIG. 2, it is a schematic diagram of the gate line structure 20 of the solar cell in this embodiment. According to FIG. 2, the gate line structure 20 includes a plurality of main gate lines 21 extending along a first direction X and arranged at intervals along a second direction Y, and in FIG. 2, two adjacent main gate lines 211 and 212 are shown.

On the other hand, the gate line structure 20 further includes a plurality of thin gate lines 22 extending along the second direction Y and arranged at intervals along the first direction X. It can be seen from FIG. 2 that the first direction X and the second direction Y are not parallel. More specifically, in the embodiment shown in FIG. 2, the first direction X is vertical to the second direction Y, but the present invention is not limited to this. On this basis, the plurality of main gate lines 21 (for example, the main gate lines 211 and 212 in the drawing) are electrically connected to the plurality of thin gate lines 22 respectively.

Particularly, in the embodiment of the present invention as shown in FIG. 2, each thin gate line 22 has a disconnected section 220 between the main gate lines 211 and 212. Compared with the un-disconnected gate line structure 10 shown in FIG. 1, the disconnected sections 220 provided on each thin gate line 22 effectively reduce the silver paste consumption as a whole and save the preparation cost of solar cells.

According to FIG. 2, the length of the disconnected section 220 of each thin gate line of the gate line structure 20 in the second direction Y is the disconnection distance d (i.e., the distance shown by the dotted line in the Y direction in FIG. 2). In some embodiments of the present invention, the disconnection distance d is less than or equal to twice the spacing a between two adjacent thin gate lines. Using such parameter settings can make the gate line structure of the present invention save silver paste consumption while minimizing the impact on the efficiency of the battery using the grid structure of the present invention.

Furthermore, considering the appearance of the prepared solar cell and the manufacturing process, in the embodiment shown in FIG. 2, the disconnection distance d of the disconnected section 220 of each thin gate line 22 is all equal. Moreover, between the adjacent main gate lines 211 and 212, the disconnected sections of all the thin gate lines 22 overlap in the first direction X.

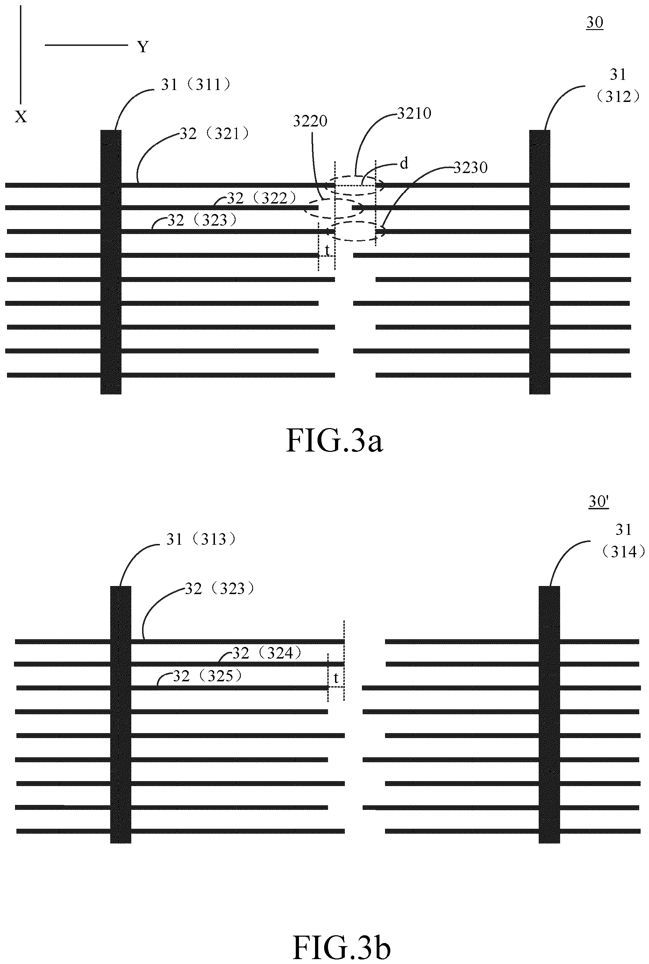

However, the present invention does not limit in all embodiments whether the distance between the disconnected sections of each thin gate line is equal and whether they overlap in the first direction X. For example, in some other embodiments of the present invention, the disconnected sections of all the thin gate lines 22 do not overlap or do not completely overlap in the first direction X, and the disconnection distances of each thin gate line are not necessarily equal. FIG. 3a-5 respectively show different situations from incomplete coincidence to non-coincidence, and the specific positions of the arrangement of the disconnected sections will be described below with reference to FIG. 3a-5. For ease of explanation, FIG. 3a-5 select the case where the disconnection distances d of the disconnection sections are equal.

In the embodiment shown in FIG. 3a, the gate line structure 30 has a plurality of main gate lines 31, wherein FIG. 3a shows two adjacent main gate lines 311 and 312 and a plurality of thin gate lines 32. Among the plurality of thin gate lines 32, the thin gate lines 321 and 323 are two odd-numbered thin gate lines. In FIG. 3a, the thin gate lines adjacent to all the odd-numbered thin gate lines are even-numbered thin gate lines, such as the thin gate line 322. Moreover, all odd-numbered thin gate lines and even-numbered thin gate lines have disconnected sections between adjacent main gate lines 311 and 312, such as disconnected sections 3210 and 3230 of odd-numbered thin gate lines 321 and 323, and the disconnected section 3220 of the even-numbered thin gate line 322.

It can be seen that, compared with the gate line structure 20 shown in FIG. 2, the plurality of thin gate lines 32 between the two adjacent main gate lines 311 and 312 in the gate line structure 30 also have disconnected sections, except that the disconnected sections of each thin gate line 32 do not completely overlap in the first direction X. Specifically, in the embodiment as shown in FIG. 3a, with reference to the auxiliary dotted line, the gate line structure 30 is particularly described in that the disconnected sections(such as the disconnected section 3210) of the odd-numbered thin gate lines(such as the thin gate line 321) and the disconnected sections(such as the disconnected section 3220) of the even-numbered fine gate lines(such as the thin gate line 322) do not completely overlap in the first direction X.

More specifically, in the embodiment shown in FIG. 3a, between adjacent main gate lines 311 and 312, any two odd-numbered thin gate lines'(such as the thin gate line 321 and 323) disconnected sections (correspondingly the disconnection sections 3210 and 3230), shown by the dotted lines in FIG. 3a, overlap in the first direction X. Similarly, although they are not clearly marked in FIG. 3a for the sake of simplicity in the drawing, the disconnected sections of any two even-numbered thin gate lines also overlap in the first direction X. However, the present invention is not limited to this, for example, in some other embodiments of the present invention, the disconnected sections of any two odd-numbered thin gate lines or any two even-numbered thin gate lines do not necessarily overlap in the first direction X.

Finally, details regarding the markings t and d in FIG. 3a and FIG. 3b will be illustrated further detail.

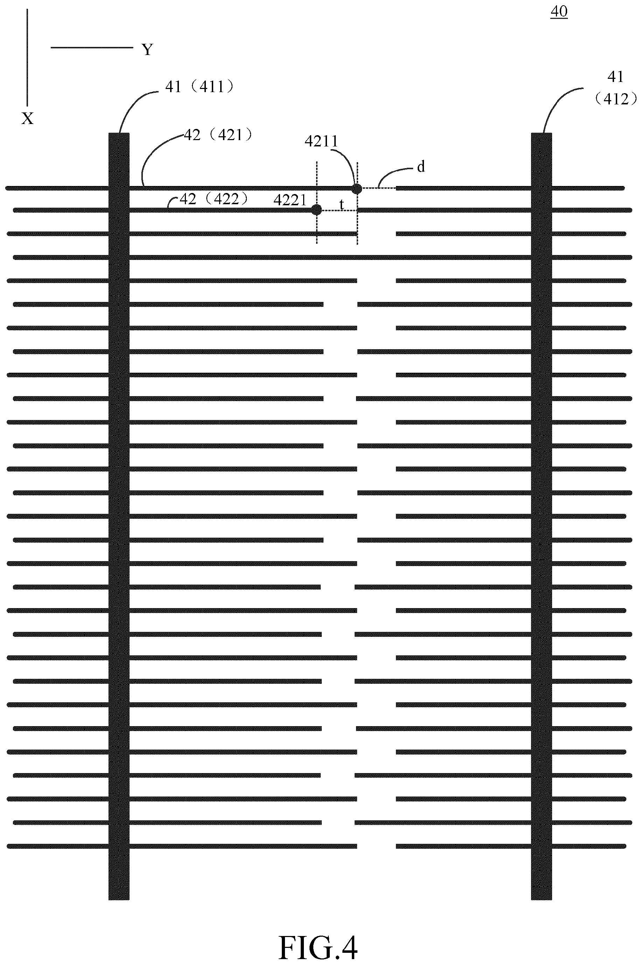

FIG. 4 shows another embodiment of the gate line structure 40 in which the disconnected sections of the thin gate lines do not overlap. In the gate line structure 40, any two adjacent main gate lines 41 are respectively the first main gate line 411 and the second main gate line 412; between the first main gate line 411 and the second main gate line 412, the end of the disconnected section (for the sake of simplicity of the drawing, the disconnection section is not specifically shown in FIG. 4, reference can be made to the above description based on FIG. 2 and 3a) of any thin gate line 42 (such as the thin gate line 421 and 422) close to the first main gate line 421 is the first end (respectively the first ends 4211 and 4221).

Further, in FIG. 4, the thin gate line 421 is odd-numbered thin gate line, and the thin gate line 422 is even-numbered thin gate line. A difference between the distance between the first end 4211 of the odd-numbered thin gate line 421's disconnected section and the first main gate line 411, and a distance between the first end 4221 of the even-numbered thin gate line 422's disconnected section and the first main gate line 411 is a stagger distance t. As mentioned above, in the embodiment shown in FIG. 4, the disconnection distance d of each thin gate line 42 is equal, and the above-mentioned stagger distance t is equal to the disconnection distance d. Using the structure as shown in FIG. 4 can reduce the consumption of silver paste and thereby reduce the preparation cost of solar cells, and at the same time obtain better cell efficiency. This effect will be further explained and verified below.

Similarly, since in the embodiment shown in FIG. 3a, the disconnected sections of each thin gate line 32 in the gate line structure 30 do not completely overlap in the first direction X, the odd-numbered thin gate line (such as the thin gate line 321) and the even-numbered thin gate line (such as the thin gate line 322) are also staggered by a distance t in the first direction X, however, in the embodiment shown in FIG. 3a, the stagger distance t is only half of the disconnection distance d.

Further, in some embodiments of the present invention, as shown in FIG. 3b, in the gate line structure 30', there are odd-numbered thin gate lines 323 and 325 and even-numbered thin gate lines 324 between two adjacent main gate lines 313 and 314. In the embodiment shown in FIG. 3b, there is a stagger distance t between the odd-numbered thin gate line 323 and another odd-numbered thin gate line 325. The present invention does not limit whether the thin gate lines with stagger distances are odd-numbered thin gate lines or even-numbered thin gate lines.

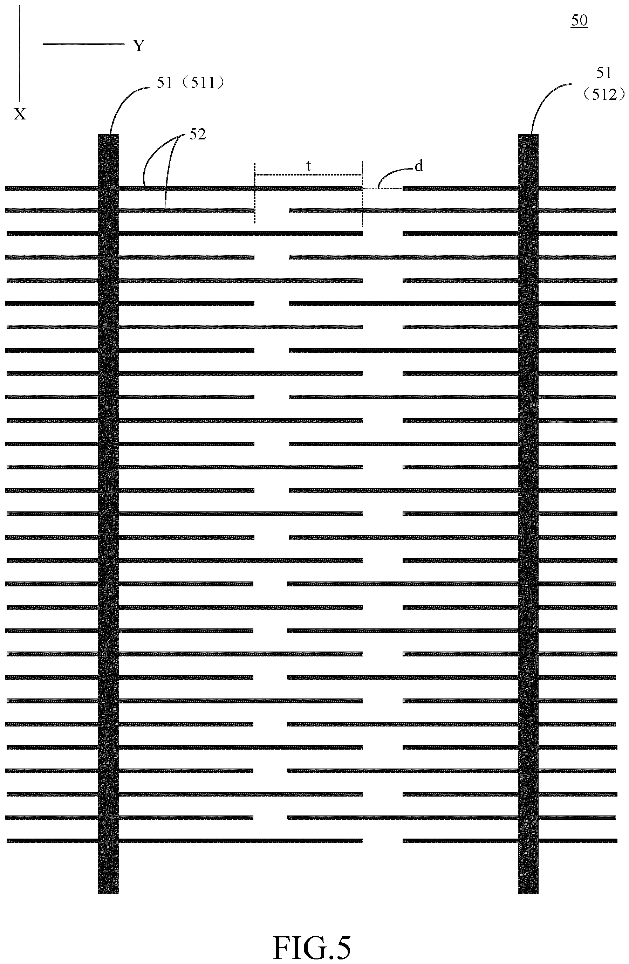

Furthermore, FIG. 5 shows an embodiment of the gate line structure 50 in which the disconnected sections of the thin gate lines do not overlap at all in the first direction X. The gate line structure 50 also has a plurality of main gate lines 51, in which the plurality of thin gate lines 52 between any two main gate lines 511 and 512 have disconnected sections, and in the embodiment shown in FIG. 5, the stagger distance t is significantly larger than the disconnection distance d. For other details about the gate line structure 50 shown in FIG. 5, please refer to the above description of FIGS. 2-4, which will not be described again here.

The gate line structures 20 to 50 shown above with reference to FIG. 2-5 are different examples in which the thin gate lines of the present invention are all disconnected, and the difference between each gate line structure lies in the position of the disconnected section and the disconnected section, as well as there exists a difference in size between the disconnected section and the stagger distance. Taking a solar cell with a side length of 158.75mm as an example, only the structure of the grid lines is changed, and as the stagger distance increases, the efficiency first increases and then decreases; and taking the disconnection distance d=2mm as an example, as the stagger distance t changes, the efficiency data of the solar cells prepared by each gate line structure corresponding to FIG. 2-5 are shown in the following table, and the Baseline in Table 1 is reference structure as shown in FIG. 1 without thin gate line disconnection:

**Table 1: Performance comparison of solar cells prepared with different gate line structures**

| Group | Voc | Isc | FF | Eff |
|---|---|---|---|---|
| Baseline | 709.348509 | 39.192504 | 82.268551 | 22.871598 |
| Gate line structure 20 | 710.128805 | 39.271922 | 81.745977 | 22.797419 |
| Gate line structure 30 | 710.209291 | 39.274807 | 81.800794 | 22.816968 |
| Gate line structure 40 | 710.171149 | 39.271922 | 81.873599 | 22.834372 |
| Gate line structure 50 | 710.176769 | 39.271922 | 81.856122 | 22.829678 |

Wherein, Voc is the open circuit voltage, Isc is the short circuit current, FF is the filling factor, and Eff is the photoelectric conversion efficiency. The control conditions for each group are as follows:
Baseline: d=0, t=0;
Gate line structure 20: d=2 mm, t=0;
Gate line structure 30: d=2 mm, t=1 mm;
Gate line structure 40: d=2 mm, t=2 mm;
Gate line structure 50: d=2 mm, t=4 mm.

It can be seen that as the stagger distance t increases, the efficiency first increases and then decreases, and when the stagger distance t is exactly equal to the disconnection distance d, it has the highest efficiency. That is, as mentioned above, the gate line structure 40 shown in FIG. 4 can have higher efficiency under the same conditions. This optimal efficiency only differs from the baseline of the reference case without disconnection as shown in Figure 1 by less than 0.05%., However, when preparing solar cells, the cost of silver consumption can be saved by about 15%. It can be seen that the use of the gate line structure of the solar cell of the present invention can effectively reduce the consumption of silver paste on the basis of ensuring the cell efficiency, thereby reducing the preparation cost of the solar cell.

On the other hand, in order to further confirm the technical effect of the solar cell gate line structure of the present invention, the present invention is also compared with the prior art's comparison structure (Baseline) when the thin gate lines are not all disconnected between any adjacent main gate lines. When the silver consumption saved by the comparison structure is equal to that of the gate line structure of the present invention, for example, the disconnection distance of the comparison structure is selected to be 2mm, and compared with the structure of the gate line structure 30 of the present invention, that is the case of d=lmm, t=0 in the present invention. Through experimental analysis, it can be concluded that the efficiency of the solar cell prepared by the gate line structure of the present invention is better than that of the comparison structure. The results are as follows:

**Table 2: Comparison of performance of solar cells prepared with gate line structure of the present invention and comparison structure**

| Group | Voc | Isc | FF | Eff |
|---|---|---|---|---|
| Baseline | 709.348509 | 39.192504 | 82.268551 | 22.871598 |
| Structure of the present invention | 710.007267 | 39.244590 | 82.158923 | 22.892716 |
| Comparison | 709.923955 | 39.244590 | 82.078330 | 22.867576 |
| structure | | | | |

From the above description, especially the experimental data analysis results, it can be seen that the gate line structure of the solar cell of the present invention can effectively reduce the silver paste consumption on the basis of ensuring the cell efficiency, thereby reducing the preparation cost of the solar cell. At the same time, compared with other comparison structures with the concept of saving silver paste consumption, the efficiency of the prepared solar cell also has better performance.

Based on the above gate line structure, another aspect of the present invention also provides a solar cell. The solar cell first includes a basic gate line structure, and the basic gate line structure is a gate line structure in which all the thin gate lines between the two adjacent main gate lines described above with reference to FIG. 2-5 have disconnected sections. In addition, in some solar cell embodiments of the present invention, on the basis of the above-mentioned basic gate line structure, a supplementary gate line structure is also included.

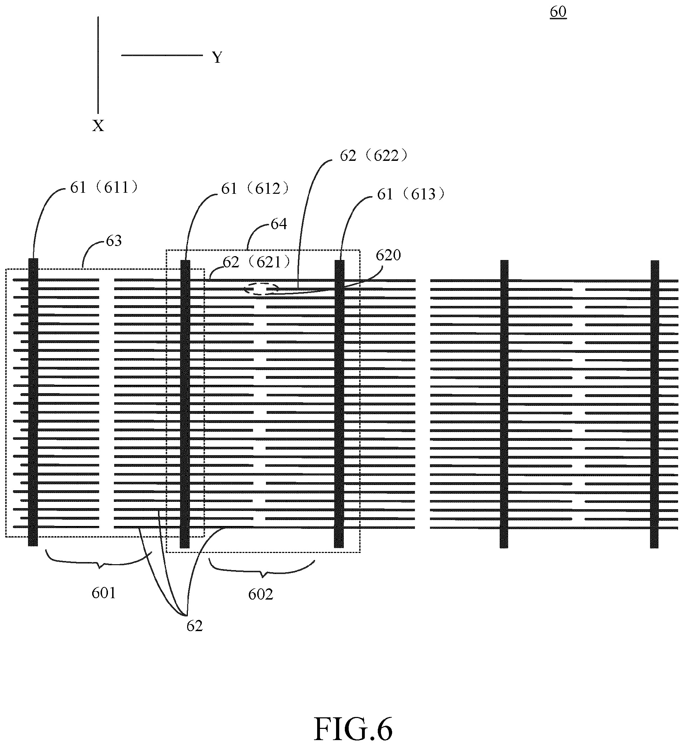

As shown in FIG. 6, it is a schematic structural diagram of a solar cell 60 according to an embodiment of the present invention. The solar cell 60 has the above-mentioned basic gate line structure and supplementary gate line structure, which will be described below with reference to FIG. 6.

According to FIG. 6, the solar cell 60 has a plurality of main gate lines 61 and a plurality of thin gate lines 62, wherein, the three main gate lines arranged in sequence are first main gate line 611, second main gate line 612 and third main gate line 613. According to FIG. 6, a first region 601 is formed between the first main gate line 611 and the second main gate line 612, and a second region 602 is formed between the second main gate line 612 and the third main gate line 613. In particular, parts of the first main gate line 611, the second main gate line 612 and the plurality of thin gate lines 62 in the first region 601 have a basic gate line structure 63. The basic gate line structure 63 in the first region 601 shown in FIG. 6 is specifically the gate line structure 20 shown in FIG. 2. However, the present invention is not limited thereto, for example, in some embodiments of the present invention, the basic gate line structure may also be the gate line structures 30 to 50 shown in FIGs. 3a-5.

Further, in FIG. 6, the second main gate line 612 and the third main gate line 613 and the plurality of thin gate lines 62 in the second region 602 have a supplementary gate line structure 64. As can be seen from FIG. 6, the supplementary gate line structure 64 includes main gate lines 612 and 613 extending along the first direction X and arranged at intervals along the second direction Y, and a plurality of thin gate lines 62 extending along the second direction Y and arranged at intervals along the first direction X. Similarly, in FIG. 6, the first direction X and the second direction Y are not parallel, and more specifically have a vertical relationship, but the present invention is not limited to this.

Based on such a structure, main gate lines 612 and 613 are electrically connected to a plurality of thin gate lines 62 respectively, and between these two main gate lines 612 and 613, only odd-numbered thin gate lines or only even-numbered thin gate lines has disconnected sections. In FIG. 6, if the thin gate lines 621 are odd-numbered thin gate lines, the thin gate lines 622 are even-numbered thin gate lines, in the embodiment shown in FIG. 6, only even-numbered thin gate included in the supplementary gate line structure 64 has a disconnected section 620.

In the embodiment shown in FIG. 6, the basic gate line structure 63 and the supplementary gate line structure 64 are arranged at intervals. It can be understood that FIG. 6 shows only a part of the solar cell 60, and a basic gate line structure 63 or a supplementary gate line structure 64 as shown in FIG. 6 is also formed between any two main gate lines that are not shown of the solar cell 60. Furthermore, the present invention does not limit the specific positions of the disconnected sections in the basic gate line structure 63 and the supplementary gate line structure 64 as shown in FIG. 6.

From the perspective of the advantages of the solar cell 60 shown in FIG. 6, if a battery all adopts a basic gate line structure, that is, all the thin gate lines between any two main grid lines are disconnected, although this can reduce silver consumption to a great extent, it also has certain limitations. Especially in the application scenario of battery testing, the IV and EL test results show that such a fully disconnected design sometimes affects the battery test results. Therefore, solar cells with all thin grid lines disconnected still have certain limitations in their application.

Specifically, when the probe during testing cannot contact the battery or the contact between the probe and the battery is poor, obvious black blocks will appear in the EL test of the solar cell. These black blocks are mainly due to the design of all the thin grid lines being disconnected, so that each main grid line and the thin grid lines connected to it are independent of each other; as a result, when the test probe on a certain main grid line is not in contact with the main grid or has poor contact, the current at that position cannot be effectively transmitted, resulting in reduced efficiency during IV testing, or local black spots during EL testing.

Adopting the structural design of the present invention in which the basic grid line structure and the supplementary grid line structure are arranged at intervals as shown in FIG. 6, the solar cell 60 has the beneficial effect of saving silver paste consumption compared to batteries with all basic grid structures; on top of that, it can further improve the black block problem that may be caused during battery testing.

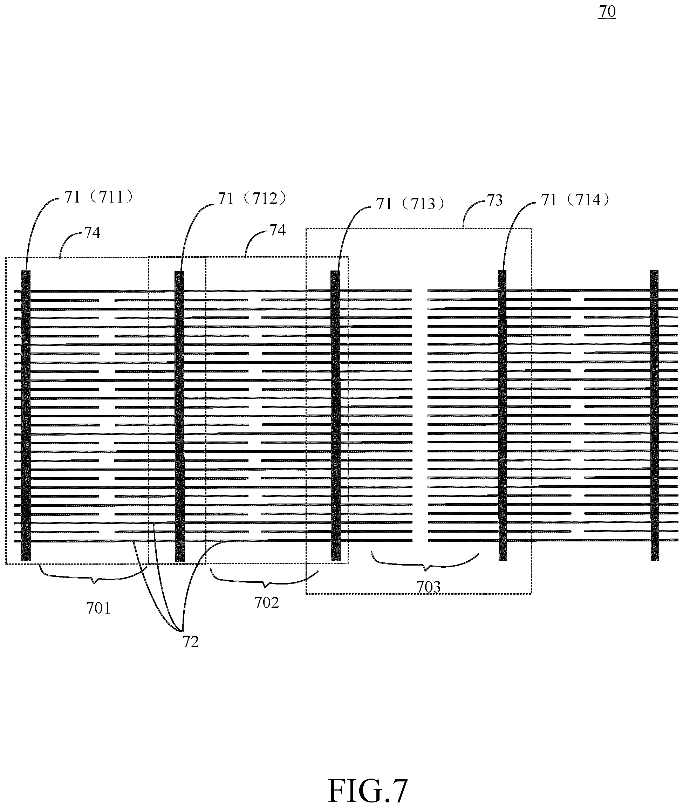

In another embodiment of the present invention, as shown in FIG. 7, a solar cell 70 also has a plurality of main grid lines 71 and a plurality of thin grid lines 72, wherein any four main grid lines arranged in sequence are selected as the first main grid line 711, the second main grid line 712, the third main grid line713 and the fourth main grid line 714; a first region 701 is formed between the first main grid line 711 and the second main grid line 712, a second region 702 is formed between the second main grid line 712 and the third main grid line 713, and a third region 703 is formed between the third main grid line 713 and the fourth main gate line 714.

Wherein, parts of the first main gate line 711, the second main gate line 712, the third main gate line 713 and the plurality of thin gate lines 72 in the first region 701 and the second region 702 are supplementary gate line structures 74, and for specific features of the supplementary gate line structure 74, please refer to the above description with reference to the supplementary gate line structure 64 in FIG. 6 which will not be described again here. Parts of the third main gate line 713, the fourth main gate line 714 and the plurality of thin gate lines 72 in the third region 703 are the basic gate line structure 73, and the basic gate line structure 73 can also be referred to the above-mentioned FIG. 2-5 which will not be repeated here.

Compared with the embodiment shown in FIG. 6, the solar cell 70 also has a structural design in which the basic grid line structure and the supplementary grid line structure are spaced apart, but the spacing method is different from the solar cell 60. In the solar cell 70, every two supplementary grid line structures 74 are followed by a basic grid line structure 73, which serves as a basic grid line structure combination. In the solar cell 60 shown in FIG. 6, it can be considered that the basic grid line structure is combined by a basic grid line structure 73 followed by a supplementary grid line structure 74. According to the comparison of experimental results, compared with the solar cell 60 shown in FIG. 6, the solar cell 70 has a better improvement effect on the black block problem in battery testing application scenarios.

The gate line structure described in the present invention with reference to FIG. 2-5 can effectively save the consumption of silver paste when preparing solar cells on the basis of ensuring cell efficiency. On this basis, the solar cell proposed by the present invention, as shown in FIG.6-7 in some embodiments, can further improve the black block problem in battery testing application scenarios on the basis of ensuring efficiency and saving silver paste consumption.

The basic concepts have been described above, obviously, for those skilled in the art, the above disclosure of the invention is only an example, and does not constitute a limitation to the present application. Although not expressly stated here, various modifications, improvements and amendments to this application may be made by those skilled in the art. Such modifications, improvements, and amendments are suggested in this application, so such modifications, improvements, and amendments still belong to the spirit and scope of the exemplary embodiments of this application.

Meanwhile, the present application uses specific words to describe the embodiments of the present application. For example, "one embodiment", "an embodiment", and/or "some embodiments" refer to a certain feature, structure or characteristic related to at least one embodiment of the present application. Therefore, it should be emphasized and noted that two or more references to "one embodiment" or "an embodiment" or "an alternative embodiment" in different places in this specification do not necessarily refer to the same embodiment. In addition, certain features, structures or characteristics of one or more embodiments of the present application may be properly combined.

In the same way, it should be noted that in order to simplify the expression disclosed in the present application and help the understanding of one or more embodiments of the invention, in the foregoing description of the embodiments of the present application, sometimes multiple features are combined into one embodiment, drawings or descriptions thereof. However, this method of disclosure does not imply that the subject matter of the application requires more features than are recited in the claims. Indeed, embodiment features are less than all features of a single foregoing disclosed embodiment.

In some embodiments, numbers describing the quantity of components and attributes are used, it should be understood that such numbers used in the description of the embodiments use the modifiers "about", "approximately" or "substantially" in some examples. Unless otherwise stated, "about", "approximately" or "substantially" indicates that the stated figure allows for a variation of ±20%. Accordingly, in some embodiments, the numerical parameters used in the specification and claims are approximations that can vary depending upon the desired characteristics of individual embodiments. In some embodiments, numerical parameters should take into account the specified significant digits and adopt the general digit reservation method. Although the numerical ranges and parameters used in some embodiments of the present application to confirm the breadth of the scope are approximate values, in specific embodiments, such numerical values are set as precisely as practicable.

Although the present application has been described with reference to the current specific embodiments, those of ordinary skill in the art should recognize that the above embodiments are only used to illustrate the present application, and various equivalent changes or substitutions can also be made without departing from the spirit of the present application, therefore, as long as the changes and modifications to the above-mentioned embodiments are within the spirit of the present application, they will all fall within the scope of the claims of the present application.

## Claims

1. A gate line structure of a solar cell, including a plurality of main gate lines extending along a first direction and arranged at intervals along a second direction, and a plurality of thin gate lines extending along the second direction and arranged at intervals along the first direction, the first direction and the second direction are not parallel, and the plurality of main gate lines are electrically connected to the plurality of thin gate lines respectively, **characterized in that**, between any two adjacent main gate lines, each thin gate line has a disconnected section.

2. The gate line structure according to claim 1, **characterized in that** a length of the disconnected section of each thin gate line in the second direction is disconnection distance, and the disconnection distance is less than or equal to twice a spacing between two adjacent thin gate lines.

3. The gate line structure according to claim 2, **characterized in that** the disconnection distance of the disconnection section of each thin gate line is all equal.

4. The gate line structure according to claim 2 or 3, **characterized in that** between any two adjacent main gate lines, the disconnected section of an odd-numbered thin gate line and the disconnected section of an even-numbered thin gate line do not overlap or do not completely overlap in the first direction.

5. The gate line structure according to claim 4, **characterized in that** between any two adjacent main gate lines, the disconnected sections of any two odd-numbered thin gate lines overlap in the first direction, and the disconnected sections of any two even-numbered thin gate lines also overlap in the first direction.

6. The gate line structure according to claim 5, **characterized in that** any two adjacent main gate lines are first main gate line and second main gate line, and between the first main gate line and the second main gate line, an end of the disconnected section of any thin gate line close to the first main gate line is first end, wherein, a difference between a distance between the first end of any odd-numbered thin gate line's disconnected section and the first main gate line and a distance between the first end of the even-numbered thin gate line's disconnected section or another odd-numbered thin gate line's disconnected section and the first main gate line is stagger distance, and when the disconnection distance of each thin gate line is equal, the stagger distance is equal to the disconnection distance.

7. A solar cell, **characterized by** including a basic gate line structure, and the basic gate line structure is the gate line structure according to any one of claims 1 to 6.

8. The solar cell according to claim 7, **characterized by** also including a supplementary gate line structure, and the supplementary gate line structure includes a plurality of main gate lines extending along a first direction and arranged at intervals along a second direction, and a plurality of thin gate lines extending along the second direction and arranged at intervals along the first direction, the first direction and the second direction are not parallel, and the plurality of main gate lines are electrically connected to the plurality of thin gate lines respectively, and between any two adjacent main gate lines, only odd-numbered thin gate lines or only even-numbered thin gate lines have disconnected sections.

9. The solar cell according to claim 8, **characterized in that** any three main gate lines arranged in sequence are a first main gate line, a second main gate line and a third main gate line, a first region is formed between the first main gate line and the second main gate line, a second region is formed between the second main gate line and the third main gate line, parts of the first main gate line, the second main gate line and the plurality of thin gate lines in the first region have the basic gate line structure, and parts of the second main gate line, the third main gate line and the plurality of thin gate lines in the second region have the supplementary gate line structure.

10. The solar cell according to claim 8, **characterized in that** any four main gate lines arranged in sequence are a first main gate line, a second main gate line, a third main gate line and a fourth main gate line, a first region is formed between the first main gate line and the second main gate line, a second region is formed between the second main gate line and the third main gate line, a third region is formed between the third main gate line and the fourth main gate line, parts of the first main gate line, the second main gate line, the third main gate line and the plurality of thin gate lines in the first region and the second region are the basic gate line structure, parts of the third main gate line, the fourth main gate line and the plurality of thin gate lines in the third region are the supplementary gate line structure.
